# EUROPEAN PATENT APPLICATION

(11) **EP 4 844 366 A1**
(43) Date of publication of application: **25.11.2026**
(21) Application number: 25177300.8
(22) Date of filing: 19.05.2025
(51) Int. Cl.: G01N 1/32, G01N 35/04, H01J 37/18

(54) **DEVICE FOR DELIVERING SAMPLES, ION MILL**

(71) Applicant: Leica Mikrosysteme GmbH, 1170 Wien (AT)
(72) Inventor: PLANK, Heinz, 1170 Wien (AT); BRETHAUER, Antje, 1170 Wien (AT); WOGRITSCH, Rainer, 1170 Wien (AT); EDTHOFER, Florian, 1170 Wien (AT); BENDER, Claus, 1170 Wien (AT); HALLADY, Andreas, 1170 Wien (AT)
(74) Representative: 2SPL Patentanwälte PartG mbB

(57) **Abstract**

The present disclosure relates to a device for delivering samples into a processing chamber of an ion mill. The device includes a storage chamber configured to store a plurality of samples. The device further includes a coupling mechanism configured to integrally connect the storage chamber to the ion mill to enable delivery of respective samples from the storage chamber to the processing chamber of the ion mill under vacuum conditions. The device further includes a sample delivery mechanism configured to sequentially deliver, under the vacuum conditions, respective samples from the storage chamber into the processing chamber of the ion mill.

## Description

### Field

The present disclosure relates to a device for delivering samples into a processing chamber of an ion mill, and to an ion mill.

### Background

In an ion mill, samples are processed using an ion beam, such as an argon ion beam, to create a flawless surface for subsequent analysis, e.g., with an electron microscope. For this purpose, samples may be mounted manually within a processing chamber of the ion mill.

In practice, the preparation and handling of such samples may involve several intermediate steps, which may be carried out under specific environmental conditions. Furthermore, depending on the application, a plurality of samples may need to be processed in succession, which may require repeated interaction with the ion mill. To address these needs, different types of sample holders, transfer systems, or auxiliary interfaces may be employed.

There may be a desire to provide improved concepts for sample delivery into an ion mill.

### Summary

This desire is addressed by the subject-matter of the independent claims. Further aspects are set forth in the dependent claims, the drawings, and the following description.

According to a first aspect, the disclosure provides a device for delivering samples into a processing chamber of an ion mill. The device includes a storage chamber configured to store a plurality of samples. The device further includes a coupling mechanism configured to integrally connect the storage chamber to the ion mill to enable delivery of respective samples from the storage chamber to the processing chamber of the ion mill under vacuum conditions. The device further includes a sample delivery mechanism configured to sequentially deliver, under the vacuum conditions, respective samples from the storage chamber into the processing chamber of the ion mill.

Thereby, automatic delivery of samples into the processing chamber may be provided and intermediate steps may be reduced, thus increasing sample throughput.

In some examples, for delivering the respective samples under vacuum conditions, the vacuum conditions are established within the storage chamber storing the samples.

Thereby, vacuum conditions may be maintained when a new sample is to be processed and the vacuum conditions might not be interrupted.

In some examples the coupling mechanism is based on a vacuum lock. In such examples, the sample delivery mechanism is configured, before delivering a respective sample into the processing chamber of the ion mill, to deliver the respective sample into the vacuum lock. The vacuum conditions are established within the vacuum lock.

Thereby, the vacuum conditions may be maintained within the processing chamber without the need to interrupt them for changing samples.

In some examples the sample delivery mechanism includes a rotation mechanism configured to, when rotated, deliver a respective sample into the processing chamber of the ion mill.

Thereby, a completed sample may be put back into the rotation mechanism before a new sample is rotated into position.

In some examples, the storage chamber is configured in a revolver-like arrangement having a sample compartment for each sample. The sample compartments are distributed about a central axis that corresponds to an axis along which the respective samples are delivered into the processing chamber of the ion mill.

Thereby, horizontal dimensions of the device may be kept small.

In some examples, the storage chamber is configured in a linear arrangement having a sample compartment for each sample. The sample compartments are aligned along a longitudinal axis that corresponds to an axis along which the respective samples are delivered into the processing chamber of the ion mill.

Thereby, a simple layout may be provided.

In some examples, the storage chamber is configured in a carrousel-like arrangement having a sample compartment for each sample. The sample compartments are distributed about a central axis that is perpendicular to an axis along which the respective samples are delivered into the processing chamber of the ion mill.

Thereby, vertical dimensions of the device may be kept small.

In some examples, the storage chamber is configured in a linear arrangement having a sample compartment for each sample. The sample compartments are aligned along a longitudinal axis that is perpendicular to an axis along which the respective samples are delivered into the processing chamber of the ion mill.

Thereby, a simple layout may be provided in which, after processing, samples may be put back into the storage chamber before a new sample is to be processed, thus minimizing intermediate steps.

In some examples, the longitudinal axis is parallel to a normal surface area of the ground.

Thereby, vertical dimensions of the device may be kept small.

In some examples, the longitudinal axis is perpendicular to a normal surface area of the ground.

Thereby, horizontal dimensions of the device may be kept small.

In some examples, the device further includes control circuitry configured to control the sequential delivery of the respective samples into the processing chamber of the ion mill.

Thereby, automated sample loading may be provided.

In some examples, the control circuitry is configured to control the sequential delivery of the respective samples by controlling a motor to advance a respective sample into the processing chamber of the ion mill.

Thereby, automated sample loading may be further enhanced.

According to a second aspect, the disclosure provides an ion mill including the device of the first aspect or of any example relating to the first aspect, and the processing chamber.

Thereby, similar effects as stated above may be achieved.

In some examples, the ion mill further includes a sample reception mechanism configured to receive a respective sample from the sample delivery mechanism. The sample reception mechanism is further configured to align the respective sample within the processing chamber of the ion mill for processing the respective sample with an ion beam.

Thereby, automated sample loading may be further enhanced.

In some examples, the ion mill further includes a sample removal mechanism configured to remove the respective sample from the processing chamber of the ion mill after processing.

Thereby, automated sample unloading may be provided.

### Brief description of the Figures

Some examples of apparatuses and/or methods will be described in the following by way of example only, and with reference to the accompanying figures, in which
Fig. 1 an example of a device for delivering samples according to the present disclosure;
Fig. 2 depicts an example of an ion mill and the device of Fig. 1;
Fig. 3 depicts a further example of an ion mill and of a device for delivering samples in a revolver-like arrangement according to the present disclosure;
Fig. 4 depicts a further example of a device for delivering samples in a linear arrangements according to the present disclosure where sample compartments are aligned along an axis corresponding to an axis where the samples are delivered into the ion mill;
Fig. 5 depicts a further example of a device for delivering samples in a carousel-like arrangements;
Fig. 6 depicts a further example of a device for delivering samples in a magazine arrangement;
Fig. 7 depicts a further example of an ion mill coupled with a device for delivering samples in a magazine arrangement;
Fig. 8 depicts a further example of a device for delivering samples in a revolver arrangement;
Fig. 9 depicts a side view of an ion mill according to the present disclosure that has a sample delivery mechanism and a distinct sample removal mechanism;
Fig. 10a depicts a schematic diagram of an example of an ion milling system according to the present disclosure; and
Fig. 10b depicts a schematic diagram of a further example of an ion milling system according to the present disclosure.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

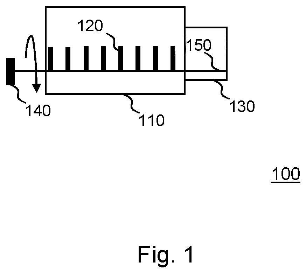

Fig. 1 depicts an exemplary device 100 for delivering samples 120 into a processing chamber of an ion mill.

An ion mill may relate to a device or system configured to perform material removal of the sample 120 using a focused or broad beam of ions under vacuum- or near-vacuum conditions, e.g., for the purpose of thinning, polishing, or structuring surfaces of the sample 120 at micro- or nanoscale resolution.

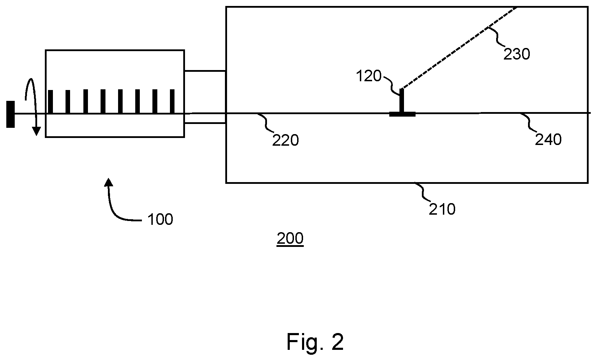

An schematic view of an ion mill 200 and the device 100 is shown in Fig. 2 and in the following, it is referred to Figs. 1 and 2.

Generally, ion mills, such as the ion mill 200, may operate by directing a beam 230 of inert gas ions (such as argon ions) toward a target surface of the sample 120, where the kinetic energy of the ions may cause atoms to be sputtered away. Ion milling may be used in the context of applications requiring precise and controlled material removal without inducing mechanical stress or significant thermal effects. For example, ion mills may be employed in the preparation of transmission electron microscopy (TEM) specimens, where extremely thin samples (e.g., thinner than 100 nanometers (nm), such as in the range of 20 to 80 nm) may be needed for electron transparency. For example, in TEM, ion milling may be used for removing surface damage layers introduced during mechanical polishing or other preparatory steps. Furthermore, ion mills may be used in failure analysis, cross-sectioning of multilayer semiconductor devices, in nanostructure fabrication, semiconductor device fabrication, materials science research, high-resolution microscopy workflows that demand atomically flat or extremely thin samples, or the like.

The ion mill 200 includes a processing chamber 210, i.e., an enclosed region in which the ion beam 230 interacts with the sample 120 to carry out material removal. The processing chamber 210 may be maintained under vacuum conditions to facilitate unimpeded ion travel and to prevent contamination during the ion milling process. The processing chamber 210 may house further components such as a sample stage, ion source alignment structures, beam diagnostics, a sample delivery mechanism 220, a sample removal mechanism 240 (but it should be noted that the sample may alternatively (depending on the use-case) be removed via the sample delivery mechanism 220 to be stored again in the device 100), and the like, ensuring precise and controlled interaction between the ion beam 230 and the sample 120. Vacuum conditions may relate to a pressure state below atmospheric pressure, e.g., established and maintained within enclosed regions of the device 100 and/or the ion mill 200 to enable ion beam processing without interference from ambient gas particles. In the context of the present disclosure, vacuum conditions may refer to low-pressure environments that support the generation, propagation, and focusing of ion beams, such as the ion beam 230, without significant scattering, attenuation, or contamination. For example, vacuum conditions may be established at least within the coupling mechanism 130 (when embodied as a vacuum lock) and the processing chamber 210 to ensure a continuous low-pressure path for sample delivery and processing, and in some examples, also in the storage chamber 110. Vacuum levels may vary depending on the specific operational requirements of the ion mill 200, and may include high vacuum (e.g., in the range of 10⁻³ to 10⁻⁷ millibar) or ultra-high vacuum (e.g., below 10⁻⁷ millibar). Establishing and maintaining such vacuum conditions may involve the use of vacuum pumps, valves, sealing elements, and the like integrated into or connected to the respective components. Vacuum conditions may serve to reduce contamination, preserve sample integrity, and maintain system performance during sequential sample delivery and ion milling. In some examples, different regions of the device 100 and the ion mill 200 may be maintained at different vacuum levels, which may be temporarily equilibrated during sample transfer through the coupling mechanism 130.

In this context, the sample 120 may relate to a physical specimen intended for the above-described material removal. For example, the sample 120 may be based on at least one of the following materials that are suitable for ion milling: silicon, glass, ceramics, metals, composite materials used in semiconductor, geological, or materials science applications, or the like.

The device 100 includes a storage chamber 110 configured to store a plurality of samples 120 (which may be the same type of samples 120 or different types of samples, e.g., based on different materials). The storage chamber 110 may form a structural component of the device 100 that is configured to store (or: hold) the plurality of samples 120 intended for subsequent processing in the processing chamber 210. It may be constructed as an enclosed or semi-enclosed compartment designed to accommodate and organize the plurality of samples 120 in defined positions, such as in individual sample compartments or slots. The storage chamber 110 may support various geometrical arrangements, including but not limited to linear, revolver-like, carousel-like configurations, or the like (as will be discussed further below), e.g., depending on the use-case. In Fig. 1, a linear arrangement is shown, but the present disclosure is not limited in that regard. To facilitate operation under vacuum conditions, the storage chamber 110 may be vacuum-sealable or integrated into a larger vacuum system, allowing samples 120 to be maintained in a contamination-free environment prior to delivery and to deliver samples 120 to be delivered into the processing chamber 210 of the ion mill 200 under vacuum conditions. For this purpose, the device 100 may include guiding or alignment elements that ensure precise sample transfer into the processing chamber (not shown). In some examples, the storage chamber 110 may also be removable or re-loadable to accommodate batch-wise sample processing.

The configuration of Figs. 1 and 2 depict a the storage chamber 110 as a linear magazine configured to store ten to twenty samples in a single row. In such an example, the chamber may be 150 millimeters (mm) to 300 mm in length, 10 mm to 20 mm in width, and 10 mm to 20 mm in height.

For a revolver-like or carousel-type configuration with radially distributed sample slots (as will be discussed below), the storage chamber 110 may have a diameter of 80 mm to 150 mm, and a thickness or height of 15 mm to 30 mm, depending on a number of sample compartments.

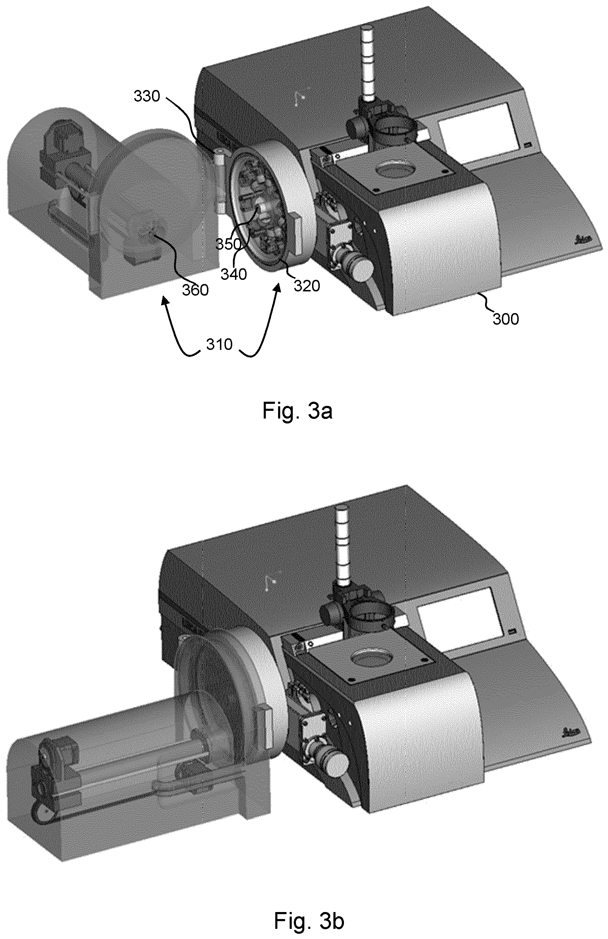

Further geometrical details will be discussed under reference of Figs. 3 to 7.

The device 100 further includes a coupling mechanism 130 configured to integrally connect the storage chamber 110 to the ion mill 200 (or to the processing chamber 210) to enable delivery of respective samples 120 from the storage chamber 110 to the processing chamber 210 under vacuum conditions.

The coupling mechanism 130 may relate to a structural and functional interface configured to connect the storage chamber 110 to the ion mill 200 in a manner that allows sample transfer under controlled conditions, particularly under vacuum conditions. The coupling mechanism 130 may serve to maintain the vacuum integrity for sample delivery from the storage chamber 110 into the processing chamber 210. In some examples, the coupling mechanism 130 includes a vacuum lock or transfer port configured to isolate the internal volumes of the storage chamber 110 and the ion mill 200 (or the processing chamber 210) during sample handover. Such a vacuum lock may be configured to receive a sample 120 from the storage chamber 110, isolate it via a set of seals and/or valves, and subsequently equilibrate the pressure with the processing chamber 210 before completing the transfer. The coupling mechanism 130 may be rigid or articulated, depending on spatial constraints and desired flexibility in system integration. It may include mechanical guides, sealing interfaces, alignment pins, docking surfaces, or the like, to ensure precise mechanical alignment between the device 100 and the ion mill 200. In some examples, the coupling mechanism 130 may further incorporate sensors or feedback systems to confirm proper positioning and vacuum status (or pressure status/level) before initiating sample transfer.

The coupling mechanism 130 is configured to integrally connect the storage chamber 110 to the ion mill 200. This may refer to a connection that is structurally and functionally unified with the ion mill, such that the device 100 and the ion mill 200 may be able to operate as a continuous system without requiring disassembly or intermediate handling. This integration may ensure seamless vacuum continuity and mechanical alignment, allowing for direct and uninterrupted transfer of samples from the storage chamber into the processing chamber.

Still, the coupling mechanism 130 may also accommodate slight misalignments or mechanical tolerances via compliant materials or active alignment elements without sacrificing the integral connection.

The coupling mechanism 130 may be designed for permanent installation or detachable use, depending on whether the device 100 is part of the ion mill 200 or a modular add-onto the ion mill 200 (i.e., a standalone device). In summary, the coupling mechanism 130 may enable sample delivery without requiring the ion mill to be vented, thus enhancing throughput, preserving vacuum stability, and reducing downtime between processing steps.

The device 100 further includes a sample delivery mechanism 140 configured to sequentially deliver, under the vacuum conditions, respective samples 120 from the storage chamber 110 into the processing chamber 210 of the ion mill 200.

The sample delivery mechanism 140 may be configured for precise, controlled, and repeatable delivery of the samples 120 without breaking the vacuum seal. The sample delivery mechanism 140 may be based on various types of motion, including linear translation, rotational indexing, or compound multi-axis movement, depending on the configuration of the storage chamber 110 and spatial orientation of the ion mill 200. In some examples, the sample delivery mechanism 140 includes a rotation mechanism configured to, when rotated, deliver respective sample into the processing chamber 210 of the ion mill 200 (e.g., through the coupling mechanism 130). The rotation mechanism may relate to any mechanism configured to advance a sample 120 into the processing chamber 210 based on a rotational movement. For example, the rotation mechanism may include a (motorized) actuator, such as a stepper motor or pneumatic piston, configured to push or pull a sample 120 along a predefined path 150 through the coupling mechanism 130 and that is connected to the sample reception mechanism 220 of the processing chamber 210, thereby providing seamless transfer of samples 120. Alternatively, it may comprise a rotating structure or carousel that brings a selected sample into alignment with the predefined path 150. The sample delivery mechanism 140 may thus be configured to interface with or pass the coupling mechanism 130, allowing samples 120 to be temporarily isolated during transfer and pressure equalization. Precision components such as rails, guides, or detents may be employed to ensure accurate positioning of each sample 120 during delivery. In some examples, the sample delivery mechanism 140 incorporates sensors, encoders, or control electronics to enable automated or semi-automated operation, supporting sequential delivery of multiple samples 120, e.g., with minimal user intervention. The sample delivery mechanism may accommodate dimensional tolerances of the samples 120 while avoiding contamination or mechanical damage during handling. Thus, the sample delivery mechanism 140 may play a critical role in the overall efficiency and reliability of the device 100, enabling high-throughput ion milling workflows without repeated venting or manual repositioning.

The sample delivery mechanism 140 may be connected to or include control circuitry configured to control the sequential delivery of the respective samples 120 into the processing chamber 210. Control circuitry may relate to one or more electronic components, modules, or systems configured to control, coordinate, and automate the operation of the device 100, in particular the sequential delivery of the plurality of samples 120 into the processing chamber 210. The control circuitry may be electrically connected to one or more actuators, motors, sensors, user interfaces, or the like, associated with at least one of the sample delivery mechanism 140, the coupling mechanism 130, and the storage chamber 110. In some examples, the control circuitry includes at least one processor, such as a microcontroller unit (MCU) or a digital signal processor (DSP), configured to execute control algorithms based on input signals and pre-programmed instructions. Additionally or alternatively, the control circuitry may include or be based on a field-programmable gate array (FPGA) to allow flexible, low-latency control of hardware operations such as motor stepping, synchronization of vacuum lock sequences, or signal conditioning. In other examples, a programmable logic controller (PLC) may be used for robust integration, e.g., when the device 100 is part of a larger automated laboratory or manufacturing system. Further, the control circuitry may include memory modules, such as EEPROM or flash memory, to store configuration data, operation logs, or sample identification numbers. Power management elements such as voltage regulators, motor drivers, and analog-to-digital converters (ADCs) may also form part of the control circuitry to interface with analog sensors and actuate electro-mechanical components.

In operation, the control circuitry may be configured to receive signals from sensors indicating at least one of the position and/or status of samples 120, the storage chamber 110, and the pressure level within the coupling mechanism 130 and/or the processing chamber 210. Based on such signals, the control circuitry may activate a stepper motor to rotate the storage chamber 110, trigger a pneumatic piston or linear actuator to advance a sample 120 into the coupling mechanism 130, or initiate pressure equilibration sequences before delivery into the processing chamber 210. In some examples, the control circuitry may be communicatively coupled to a user interface, such as a touchscreen display or a remote control panel, allowing a user to select a specific sample 120, define milling sequences, monitor the status of ongoing operations, or the like. The control circuitry may also support communication protocols such as UART, SPI, I²C, CAN, or Ethernet to interface with external systems, e.g., laboratory information management systems (LIMS) or centralized control units in high-throughput facilities. Thus, the control circuitry may enable autonomous, precise, and repeatable sample handling operations that enhance the reliability, throughput, and ease of use of the device 100.

As an example, the sample delivery mechanism 140 as depicted in Figs. 1 and 2 is configured for linear sample delivery into the processing chamber 210. For this purpose, the sample delivery mechanism 140 is embodied as an actuator that, when rotated, causes the samples to be advanced into the coupling mechanism 130 that is embodied as a vacuum lock in this example. Once a sample 120 is in the coupling mechanism 130, vacuum conditions are established in the coupling mechanism 130 and in the processing chamber 210. When pressure is equilibrated between the coupling mechanism 130 and the processing chamber 210, the sample 120 is advanced, via the sample reception mechanism 220, onto a sample stage to be processed with an ion beam. 3.

In other words, in some examples, the coupling mechanism 130 is based on a vacuum lock. In such examples, the sample delivery mechanism 140 is configured, before delivering a respective sample 120 into the processing chamber 210, to deliver the respective sample 120 into the vacuum lock, and the vacuum conditions are established within the vacuum lock.

The predefined path 150 that goes through the coupling mechanism 130 may seamlessly connect to the sample reception mechanism 220. For example, an assembly-line-like structure may be used to advance the sample 120 for seamless delivery to the sample stage. In this example, a sample removal mechanism 240 is provided and the sample 120 may be further advanced onto another opening of the processing chamber 210 that may have a further vacuum lock, in some examples. However, in some examples, the sample 120 is removed over the same path as it was advanced into the processing chamber 210, i.e., via paths 220 and 150.

Fig. 3 depicts an example of an ion mill 300 and a device 310 in a revolver-like (or Ferris wheel-like) arrangement for delivering samples into a processing chamber of the ion mill 300. Fig. 3a depicts the case in which the device 310 is open such that a storage chamber 320 of the device 310 can be loaded, while Fig. 3b depicts the case in which the device 310 is closed such samples (not shown in this example) can be delivered into the processing chamber of the ion mill 300. For loading the device 310, a hinge 330 is provided such that, while the device 310 is opened, the storage chamber 320 can remain coupled (via a coupling mechanism as described herein - not show) to the ion mill 300 (without limiting the present disclosure in that regard).

As can be taken from Fig. 3a, the storage chamber 320 includes a plurality of sample compartments 340 that are distributed about a central axis 350. In each sample compartment 340, a sample can be loaded, and respective samples can be delivered into the processing chamber via an axis that corresponds to the central axis 350. For example, a sample delivery mechanism may be based on a piston 360 may be provided along an axis that is parallel to the central axis 350 (and thus, corresponds to the central axis 350). The piston 360 may be provided at a position such that, when the device 310 is closed (as shown in Fig. 3b), the piston 360 can used to advance (e.g., by pushing) a sample along a predefined path into the ion mill 300, as described herein.

In general terms, the revolver-like arrangement may refer to a rotational geometry in which the sample compartments 340 are positioned radially around the central 350 axis, similar in configuration to the cylinder of a revolver firearm. In such a configuration, the storage chamber 320 may include a cylindrical or polygonal drum structure that is rotatable about the central axis 350, and each sample compartment 340 may be positioned at a fixed angular interval relative to an adjacent sample compartments 340. The sample compartments 340 may be configured as bores, cavities, sockets, or the like, within the drum, extending either radially inward or parallel to the axis of rotation, depending on the specific sample delivery mechanism.

For example, in the storage chamber 320, samples may be delivered along a horizontal delivery axis and the central axis 350 of the drum may lie in parallel with the to the horizontal delivery axis (e.g., along the axis of the piston 360, as describe above). The storage chamber may be rotatable in discrete angular increments, e.g., by 5°, 30°, 45°, 60°, or the like, to index the next sample into position, and may be actuated by a motor, gear system, manual rotation mechanism, or the like, as discussed herein.

The rotational motion of the storage chamber 110 may be controlled by control circuitry (as discussed under reference of Figs. 1 and 2) configured to position a selected sample compartment 340 in alignment with the sample delivery mechanism. Upon rotational indexing, the aligned sample 120 may be delivered along the predefined path 150, for instance by the piston 360, a pushing rod, or similar actuator that traverses the axis of the corresponding sample compartment. To ensure vacuum compatibility, the revolver-like storage chamber 320 may be housed within a vacuum-tight enclosure and equipped with dynamic seals or rotary feedthroughs at the rotational interface, but the present disclosure is not limited in that regard as in an alternative example, a vacuum lock may be provided, as discussed above.

The number of sample compartments may vary depending on the outer diameter of the drum and the spacing required between samples. For instance, if the drum has a diameter in the range of 80 mm to 150 mm and accommodates samples with a diameter of approximately 3 mm, the revolver-like storage chamber 320 may comprise six to twelve compartments evenly spaced around the circumference. In some examples, the sample compartments may be tilted or angled slightly relative to the radius to optimize the mechanical guiding of the sample into the delivery path.

Such an arrangement may allow for compact, high-density sample storage in a geometrically efficient format. Furthermore, the revolver-like arrangement may facilitate quick sample selection and alignment without requiring translational motion of the storage chamber 340. The device 310 may further be modular, allowing the storage chamber 340 to be removed or exchanged with a new (preloaded) unit for batch processing. In summary, the revolver-like arrangement offers a mechanically robust and vacuum-compatible design for organizing and delivering a plurality of samples into the processing chamber.

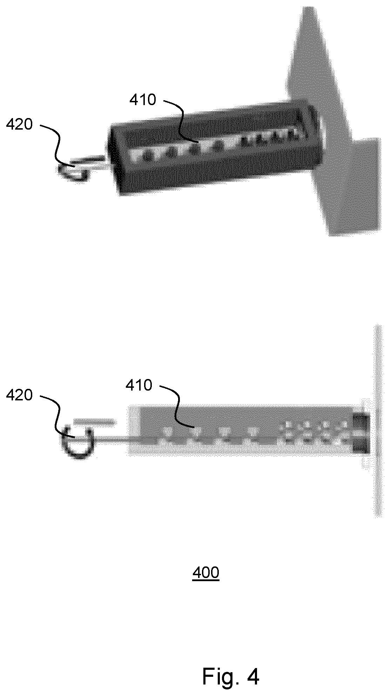

Fig. 4 depicts an example of a device 400 for delivering samples in a stereometric view (top) and in a side view (bottom). Basically, the device 400 corresponds to the device 100, as discussed under reference of Figs. 1 and 2, but in this example, vacuum conditions are established in the whole storage chamber.

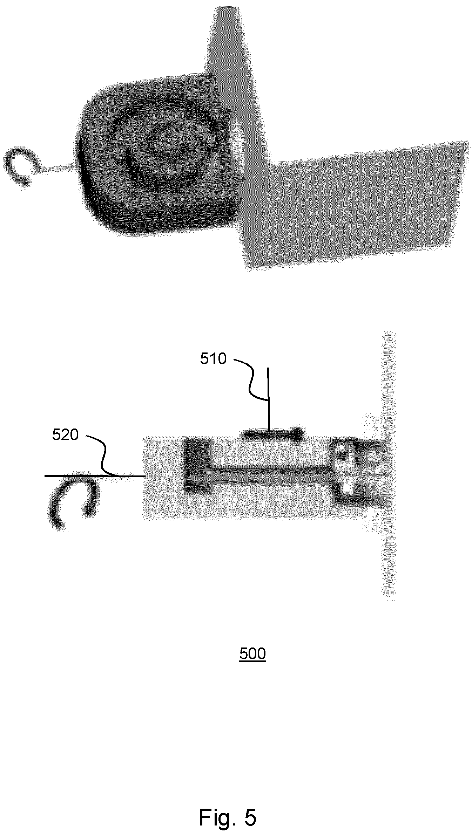

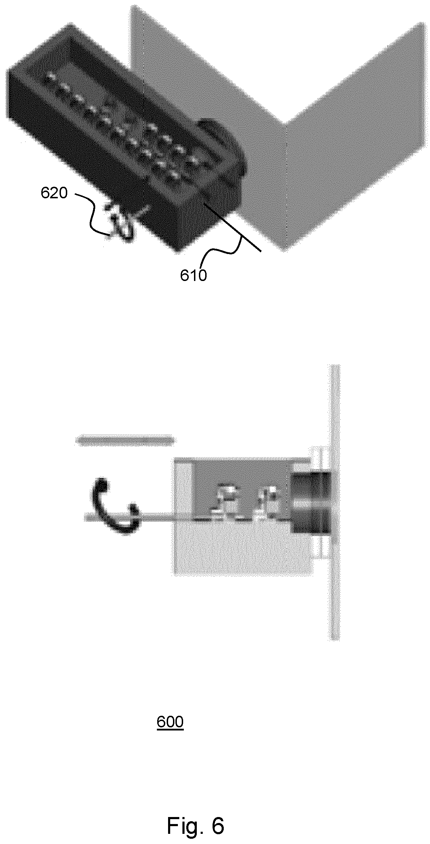

In general terms, the device 400 is configured in a linear arrangement having a sample compartment 410 for each sample. The sample compartments 410 are aligned along a longitudinal axis 420 that corresponds to an axis along which the respective samples are delivered into the processing chamber of the ion mill. As in Fig. 2, after processing, samples may be removed from the processing chamber based on a sample removal mechanism. In contrast to that, Fig. 3 depicts an example where, after processing, samples can be put back into their original position of the storage chamber (as also in Figs. 5 and 6).

Fig. 5 depicts an example of a device 500 for delivering samples in a stereometric view (top) and a side view (bottom). The device 500 is configured in a carousel-like arrangement. As the other examples, the carousel-like arrangement also includes a sample compartment for each sample. The sample compartments are distributed about a central axis 510 that is perpendicular to an axis 520 along which the respective samples are delivered into the processing chamber.

In general terms, the carousel-like arrangement may refer to a rotatable platform or disc structure in which the sample compartments are arranged in a circular pattern around the central axis 510, similar in principle to the rotation of a traditional carousel or turntable. In contrast to a revolver-like arrangement where the central axis may be aligned with the delivery direction, the carousel configuration may be characterized by its orthogonal orientation, where the delivery direction extends tangentially or radially relative to the circular layout of the sample compartments.

The sample compartments may be mounted or embedded at equidistant positions along the rotatable platform or disc structure. The central axis 510 may extend vertically or horizontally, depending on the system configuration, while the sample delivery mechanism (along the axis 520) may be oriented such that it accesses a selected sample from the periphery or from a radially inward-facing surface. Upon rotation of the carousel, a selected sample may be brought into a predefined alignment position corresponding to the entry point of the coupling mechanism. The selected sample may then be delivered along a predefined path into the processing chamber.

To enable precise indexing, the carousel-like structure may be incrementally rotatable, e.g., via a stepper motor, gear train, or other rotational drive system controlled, e.g., by control circuitry as discussed above (e.g., under reference of any one of Figs. 1 to 4). Each indexing step may correspond to the angular distance between adjacent sample compartments, ensuring that only one sample is accessible at a time.

For example, a disc with a diameter of 100 mm to 150 mm may hold 8 to 16 (or more) evenly spaced samples along its circumference, depending on the sample size and spacing. This configuration may be used in systems where vertical space is limited or where lateral access to the processing chamber is preferred. The use of a carousel-like structure may also reduce the linear motion requirements of the sample delivery mechanism, potentially simplifying the mechanical design, in particular with respect to removal of a sample as it may be removed via the same path as it entered the processing chamber. Overall, the carousel-like storage chamber may provide an efficient and space-saving arrangement for sequentially delivering a plurality of samples into the processing chamber under vacuum conditions.

In some examples, the storage chamber is configured in a linear arrangement. The sample compartments may be aligned along a longitudinal axis that is perpendicular to an axis along which the respective samples are delivered into the processing chamber of the ion mill. Such a configuration may be based on a linearly elongated structure, such as a guide rail, rack, compartmented housing, or the like, in which the plurality of samples is arranged in individual slots that are spatially separated and fixed along the longitudinal axis. The delivery of the samples may occur orthogonally to the alignment of the longitudinal axis, such that a selected sample is moved from its resting position into the predefined path intersecting the coupling mechanism or leading directly into the processing chamber. The linear arrangement may allow for modular construction, easy loading and unloading, and straightforward mechanical design while preserving precise positioning and vacuum compatibility.

In one example, the longitudinal axis may be parallel to a normal surface area of the ground, such that the storage chamber is horizontally oriented and resembles a magazine arrangement. Such an example is depicted Fig. 6 (top: stereoscopic view; bottom: side view) showing a device 600 and the longitudinal axis 610 and the axis 620 along which the samples are delivered into the processing chamber. In this configuration, the sample compartments may be arranged side-by-side along the horizontal length of the storage chamber, with each compartment configured to receive a sample, such as a 3 mm TEM sample, or the like. The magazine arrangement may be embodied as a rectangular enclosure or channel guide, with exemplary dimensions of 150 mm to 300 mm in length, 15 mm to 30 mm in width, and 15 mm to 30 mm in height, depending on the number of sample compartments. Each compartment may be spaced at regular intervals of 5 mm to 10 mm (or less), allowing for a total capacity of 10 to 30 samples in a single row. A sample delivery mechanism, such as a motorized pusher or guided slide, may be disposed beneath or beside the magazine arrangement, configured to selectively engage and advance one sample per delivery cycle along a vertical or angled delivery axis.

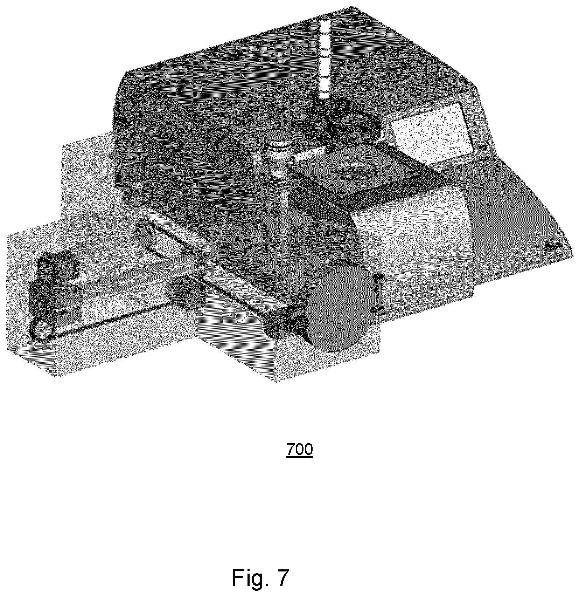

Fig. 7 depicts a more detailed view of an ion mill 700 (similar to the ion mill 300) coupled to a device for delivering samples in a magazine arrangement as described under reference of Fig. 6, such that a repetitive description is omitted.

In another example of a linear arrangement, the longitudinal axis may be perpendicular to a normal surface area of the ground, such that the storage chamber is vertically oriented in the form of a lift arrangement. In this case, the sample compartments may be arranged in a vertically stacked manner, with the longitudinal axis pointing upward and aligned with the direction of gravity. The structure may resemble a chute or column, or the like, with internal shelves, grooves, baskets, or the like, for accommodating individual samples. The lift configuration may have a dimensions of 30 mm x 30 mm and a height of 150 mm to 250 mm, again depending on the number of samples to be stored and the specific use-case. A horizontal sample delivery mechanism may be located adjacent to a designated output position near the base or middle section of the storage chamber, allowing for lateral extraction of a selected sample into the delivery path. In some examples, a vertical actuator or elevator stage may be provided to index the sample stack upward or downward, enabling the alignment of the next sample with the delivery position.

Both the magazine and lift configurations may support sequential access to samples along a direction orthogonal to their storage alignment and may be optimized for integration into space-constrained laboratory environments. The geometrical structure may further be selected based on the available orientation of the processing chamber interface and the preferred dimensions of the device. In either case, the linear storage arrangement may provide an efficient and scalable solution for organizing and delivering a plurality of samples into the ion mill under vacuum conditions.

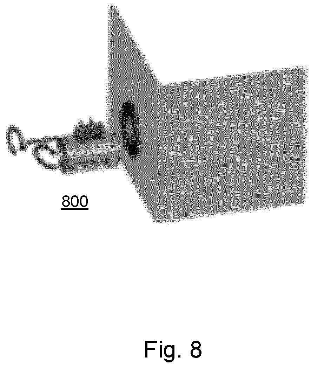

Fig. 8 depicts an example of a device 800 for delivering samples in a stereometric view in a revolver arrangement. In contrast to the device 310 of Fig. 3, the device 650 is more compact such that on the one hand, less samples may be stored therein, but on the other hand, it may be easier to handle and to connect to the ion mill. Apart from that, the explanation given above may also be applied to the example of Fig. 7.

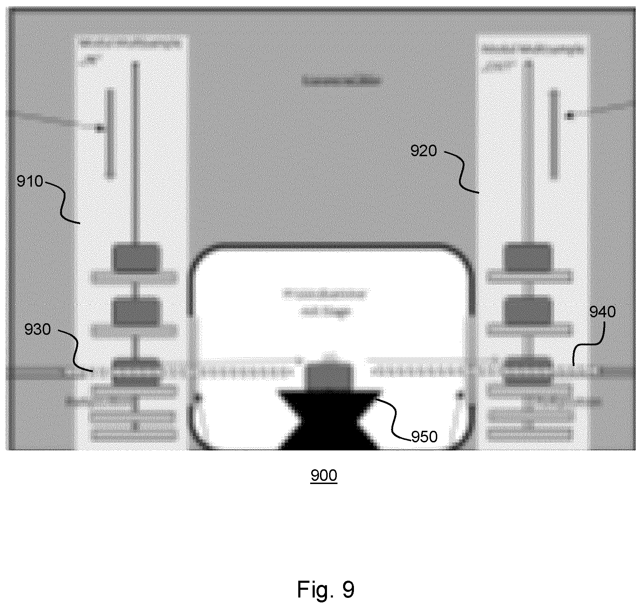

Fig. 9 depicts a side view of an ion mill 900 that includes a device for delivering samples 910 and a device for removing samples 920. The device for delivering samples 910 includes a sample delivery mechanism 930 that is connected with a sample delivery mechanism in the ion mill. Likewise, the device for removing samples 920 includes a sample removal mechanism 940 that is connected with a sample removal mechanism in the ion mill 900.

The device 910 as well as the device 920 are configured in a revolver (or Ferris-wheel) arrangement. By rotating the sample slots of device 910, a respective sample can be brought into position to be delivered, by the sample delivery mechanism 930, onto a sample stage 950 in the ion mill 900. Similarly, for removing the sample from the sample stage 950, it may be brought onto an empty slot of the device 920 by the sample removal mechanism 940 and a new empty slot may be rotated into position to receive the next sample.

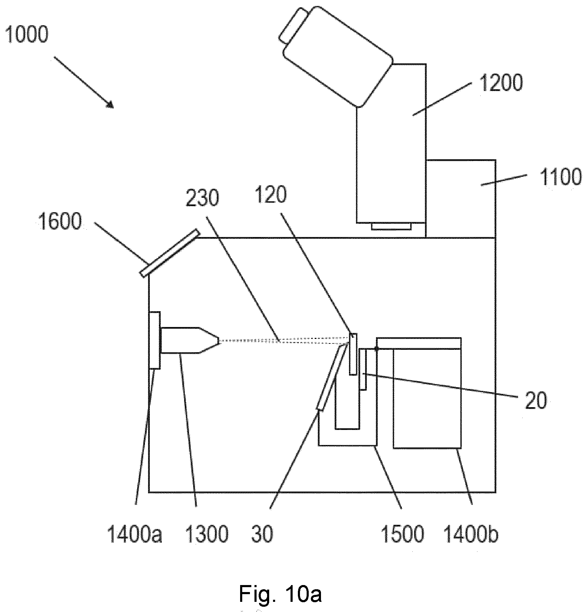

Fig. 10a shows a schematic diagram of an example of an ion milling system 1000 during ion milling of a sample 120. An ion milling system 1000 typically comprises several components. These include at least one ion emitter 1300, which comprises the ion source that generates the ion beam (commonly using Argon gas) and ion optics, which are used to direct the beam 230 onto the sample 120. A mechanical ion beam positioning system 1400a is used to target the sample by adjusting at least one of a lateral position, vertical position, or orientation of the at least one ion emitter 1300.

A sample stage 1500 holds and precisely positions the sample during processing. The sample 120 is attached to a sample holder, which is mounted to the sample stage 1500. A mask 30 partially shields the sample 120 during ion milling. A mechanical sample stage positioning system 1400b is used to position the sample stage 1500 with the sample 120 relative to the ion beam 230, with the mechanical sample stage positioning system 1400b being configured to adjust at least one of a lateral position, vertical position, or orientation of the sample stage 1500, and therefore of the sample 120. The ion milling system 1000 may also use vacuum equipment to maintain vacuum conditions, as discussed herein. Finally, a control system 1100 controls the operation and parameters of the ion milling process, allowing for adjustments to be made for different applications and material types. The control system 1100 can be controlled via a touch-screen display 1600, which is coupled to the control system 1100.

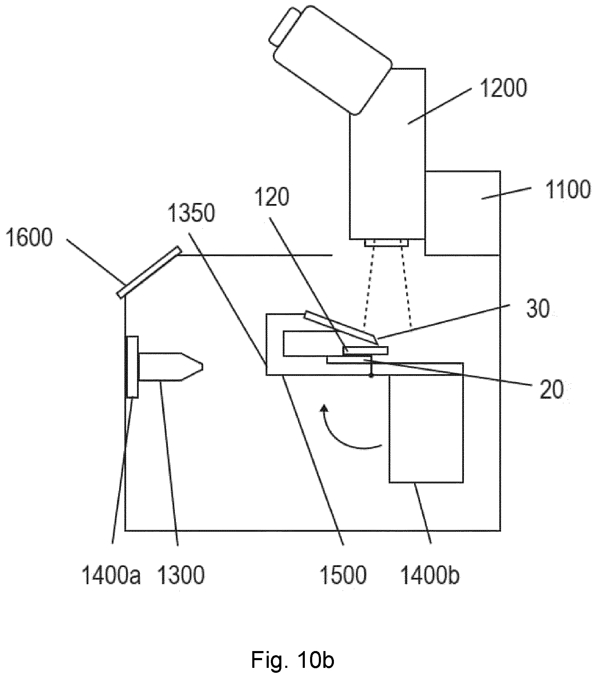

In the ion milling system 1000 shown in Figs. 10a and 10b, a digital or hybrid microscope 1200 allows a user to inspect the sample 120 that is placed on the sample stage 1500. The control system 1100 uses image data from the microscope 1200, which performs the function of an imaging device. Alternatively, a camera may be placed in the chamber of the ion milling system 1000 and be used to monitor the sample before and after the ion milling. As the sputtering leads to deposition of material removed from the sample on the components inside the ion milling chamber, the camera may be shielded from the sample chamber during ion milling, e.g., using a retractable shield, which may be removed periodically or occasionally to allow for monitoring of the progress of the ion milling process.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A device (100; 310; 400; 500; 600) for delivering samples (120) into a processing chamber (210) of an ion mill (200; 300; 700; 1000), the device (100) comprising:
a storage chamber (110; 320) configured to store a plurality of samples (120);
a coupling mechanism (130) configured to integrally connect the storage chamber (110; 320) to the ion mill (200) to enable delivery of respective samples (120) from the storage chamber (110; 320) to the processing chamber (210) of the ion mill (200; 300; 700; 1000) under vacuum conditions; and
a sample delivery mechanism (140; 360) configured to sequentially deliver, under the vacuum conditions, respective samples (120) from the storage chamber (110; 320) into the processing chamber (210) of the ion mill (200; 300; 700; 1000).

2. The device (100; 310; 400; 500; 600) of claim 1, wherein, for delivering the respective samples (120) under vacuum conditions, the vacuum conditions are established within the storage chamber (110; 320) storing the samples (120).

3. The device (100; 310; 400; 500; 600) of claim 1, wherein the coupling mechanism (130) is based on a vacuum lock,
wherein the sample delivery mechanism (140; 360) is configured, before delivering a respective sample (120) into the processing chamber (210) of the ion mill (200; 300; 700; 1000), to deliver the respective sample (120) into the vacuum lock,
and wherein the vacuum conditions are established within the vacuum lock.

4. The device (310) of any one of claims 1 to 3, wherein the sample delivery mechanism (360) comprises a rotation mechanism configured to, when rotated, deliver a respective sample into the processing chamber (210) of the ion mill (300).

5. The device (310) of any one of claims 1 to 4, wherein the storage chamber (320) is configured in a revolver-like arrangement having a sample compartment (340) for each sample (120), wherein the sample compartments (340) are distributed about a central axis (350) that corresponds to an axis along which the respective samples (120) are delivered into the processing chamber (210) of the ion mill (300).

6. The device (100; 400) of any one of claims 1 to 4, wherein the storage chamber (110) is configured in a linear arrangement having a sample compartment (410) for each sample (120), wherein the sample compartments (410) are aligned along a longitudinal axis (420) that corresponds to an axis along which the respective samples (120) are delivered into the processing chamber (210) of the ion mill (200).

7. The device (500) of any one of claims 1 to 4, wherein the storage chamber (110) is configured in a carrousel-like arrangement having a sample compartment for each sample (120), wherein the sample compartments are distributed about a central axis (510) that is perpendicular to an axis (520) along which the respective samples (120) are delivered into the processing chamber (210) of the ion mill (200; 300; 700; 1000).

8. The device (600) of any one of claims 1 to 4, wherein the storage chamber (110) is configured in a linear arrangement having a sample compartment for each sample (120), wherein the sample compartments are aligned along a longitudinal axis (610) that is perpendicular to an axis (620) along which the respective samples (120) are delivered into the processing chamber (210) of the ion mill (200; 300; 700; 1000).

9. The device (600) of claim 8, wherein the longitudinal axis (610) is parallel to a normal surface area of the ground.

10. The device of claim 8, wherein the longitudinal axis (610) is perpendicular to a normal surface area of the ground.

11. The device (100; 310; 400; 500; 600) of any one of claims 1 to 10, further comprising control circuitry configured to control the sequential delivery of the respective samples (120) into the processing chamber (210) of the ion mill (200; 300; 700; 1000).

12. The device (100; 310; 400; 500; 600) of claim 11, wherein the control circuitry is configured to control the sequential delivery of the respective samples (120) by controlling a motor to advance a respective sample into the processing chamber (210) of the ion mill (200; 300; 700; 1000).

13. An ion mill (200; 300; 700; 1000) comprising:
the device (100; 310; 400; 500; 600) of any one of claims 1 to 12; and
the processing chamber (210).

14. The ion mill (200; 300; 700; 1000) of claim 13, further comprising a sample reception mechanism (220) configured to:
receive a respective sample (120) from the sample delivery mechanism (140; 360); and
align the respective sample (120) within the processing chamber (210) of the ion mill (200; 300; 700; 1000) for processing the respective sample (120) with an ion beam (230).

15. The ion mill (200; 300; 700; 1000) of claim 13 or 14, further comprising a sample removal mechanism (240) configured to remove the respective sample (120) from the processing chamber (210) of the ion mill (200; 300; 700; 1000) after processing.
